# EUROPEAN PATENT APPLICATION

(11) **EP 0 635 700 A1**
(43) Date of publication of application: **25.01.1995**
(21) Application number: 94111237.7
(22) Date of filing: 19.07.1994
(51) Int. Cl.: G01D 5/249, H03M 1/22

(54) **Absolute digital position encoder**

(30) Priority: 22.07.1993 US 96047; 25.02.1994 US 201739
(71) Applicant: Brandestini, Marco, Dr., CH-6926 Montagnola (CH)
(72) Inventor: Brandestini, Marco, Dr., CH-6926 Montagnola (CH)
(74) Representative: Flach, Dieter Rolf Paul, Dipl.-Phys.

(57) **Abstract**

A method and apparatus to convert absolute angular or linear position to digital information utilizes a single track. Multiple sensors are placed at essentially equal intervals along a track, especially a single track. The output from the group of sensors is converted to natural binary format by combinatorial logic. The sensors may be of different types, for example maybe mechanical contacts, optical, magnetic/inductive, or capacitive transducers, and may distinguish two or more levels each. Such an encoder can be used as a potentiometer, multiposition switch, shaft encoder, or as length measurement device. The code is of the Gray-code kind, in other words adjacent positional readings have a Hamming distance of one.

## Description

### FIELD OF THE INVENTION

This invention relates to the task of converting angular or linear mechanical position to a digital output and, more particularly, to an absolute digital position encoder having a single track.

### BACKGROUND OF THE INVENTION

Presently, a number of schemes exist to convert angular or linear mechanical position to a digital output. The most simple converters are potentiometers. Their analog output can then be converted to a digital format. In a case calling for an output signal that consists of discrete steps, a multiposition switch is the present choice.

With the advance of microprocessor-based equipment, digital incremental encoders have emerged. They typically employ a single track and two sensors arranged to produce a pair of outputs in quadrature. An up/down counter is connected to the sensor outputs to deliver position information. If a second track bearing an index marker is provided, the counter can be reset when the index position is sensed. Thus a quasi-absolute scheme results, in that accurate position information can be provided so long as power remains on, but after a power-up condition the position information is not accurate until the reference position is reached in which the index marker zeroes the counter.

Where true absolute information is required multi-track encoders are the most common choice. They feature multiple parallel tracks, their number being roughly equivalent to the ²log of the number of steps to be resolved, for example 8 tracks for a 256 step encoder. Such encoders most commonly utilize an optical scheme with a photographically fabricated coding wheel bearing a Gray code.

Other principles are inductive or capacitive resolvers. Both schemes are by nature analog; from the amplitude ratio of their two- or three-phase outputs the rotary angle is computed. Synchros are a good example of a three-phase inductive rotary encoder. A straight position encoder of this type is found in digital calipers.

One object of the invention is to provide an encoding principle which can yield a digital absolute angular or linear position reading without the need for a large number of parallel tracks.

### SUMMARY OF THE INVENTION

A method and apparatus to convert absolute angular or linear position to digital information utilizes a single track. Multiple sensors are placed at essentially equal intervals along a track (or along half of a track), especially a single track. The output from the group of sensors is converted to natural binary format by combinatorial logic. The sensors may be of different types, for example may be mechanical contacts, optical, magnetic/inductive or
capacitive transducers, and may distinguish two or more levels each. Such an encoder can be used as a potentiometer, multiposition switch, shaft encoder, or as length measurement device. The code is of the Gray-code kind, in other words adjacent positional readings have a Hamming distance of one.

The objects and purposes of the invention are met according to one form of the present invention by providing a method and an apparatus of generating a numerical value representing an absolute position of a first member with respect to a second member where the first and second members are supported for relative movement, including the steps of: providing on the first member an elongate track having a code extending therealong; sensing the code at a plurality of locations on the second member which are adjacent the track at spaced locations therealong, the track moving past each location during relative movement of the first and second members; generating a set of digital values which each represent a currently-sensed code value at a respective one of the locations; and converting the set of digital values representing currently sensed code values into a final binary output representative of an absolute position of the first member with respect to the second member.

One principal feature is the ability to encode the information on a single track, thus reducing the size of an embodiment utilizing the inventive approach.

Another unique feature is the fact that the method preserves the Gray code property, i.e. only one bit of the digital value changes between the readings corresponding to two adjacent locations.

A physical implementation of the present invention is a general purpose input device to control volume, station select, temperature, etc.

Another set of applications are shaft or linear encoders. In accordance with the inventive principle, these devices yield absolute digital information at low cost and low power consumption.

The physical embodiment of the invention can have sensors based on mechanical, optical, magnetic/inductive or capacitive effects.

### BRIEF DESCRIPTION OF THE DRAWINGS

Figure 1 is a diagrammatic perspective view of an absolute 48-step position encoder;
Figure 2 is a diagrammatic view of an embodiment of the invention, which is based on a binary coding scheme featuring 60 unique positional readings a contacting detection arrangement and a serial output;
Figure 3 is a diagrammatic view of another embodiment which also utilizes a set of sliding contacts but features a ternary coding principle;
Figure 4 is a diagrammatic illustration of a comparator and code converter arrangement to generate absolute binary output data from the sliding contact encoder of figure 3;
Figure 5 is a diagrammatic illustration of a further embodiment utilizing a selectively magnetized rotor plus three Hall-effect sensors;
Figure 6 is a list of all tht ternary states defined by the encoder of figure 5;
Figure 7 is a diagrammatic view of still another encoder, which is based on a capacitive principle utilizing sector shaped electrodes as sensors and AC excitation;
Figure 8 is a diagrammatic view of the electronic excitation, amplification, and synchronous detection circuitry utilized to distinguish the three levels in a capacitive encoding scheme; and
Figure 9 is a diagrammatic view of still another embodiment of the invention, based on a quaternary coding scheme featuring 256 unique positional readings and optical detection.

### DESCRIPTION OF THE PREFERRED EMBODIMENT

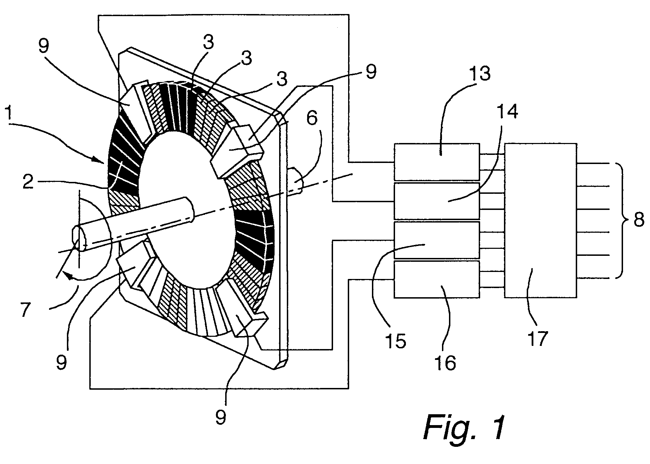

An absolute digital position encoder embodying the invention is shown in Figure 1. A disc 1 features a circular track 2 which has been subdivided into several sectors 3 and the disk 1 is mounted on a rotatably supported shaft 6 The angular position 7 of the disc is the physical input variable to be converted to an electronic digital output 8. Four stationary sensors 9 are placed at equal angular intervals to detect a ternary code pattern on the annular track 2. The signals from the sensors 9 to 12 are fed to a bank of comparators 13 to 16 (in this example each of them is a three-level-comparator), each distinguishing three output states, which in turn feed a code converter 17. The final output 8 of the code converter is an absolute binary code (6 bit binary word) corresponding to the angular position 7 of the disc 1 in a discrete proportional fashion.

A ternary coding scheme reduces the number of required sensors, and is particularly appropriate for values that naturally feature three states, such as contacting, magnetic and/or capacitive encoders.

The arrangement of the sector 3 and the code values is in such a way that during one rotation of the coding disc 1 each word only occurs once. This means that a resolution is obtained that corresponds to 360° devided through the numbers of sectors. Further this result is obtained using only one single track with several sectors.

Under certain circumstances it is, however, more advantageous to utilize a binary code:
a) When three levels are hard to define.
b) When the encoder is directly interfaced to an off-the-shelf electronic component ( ROM or driver ).

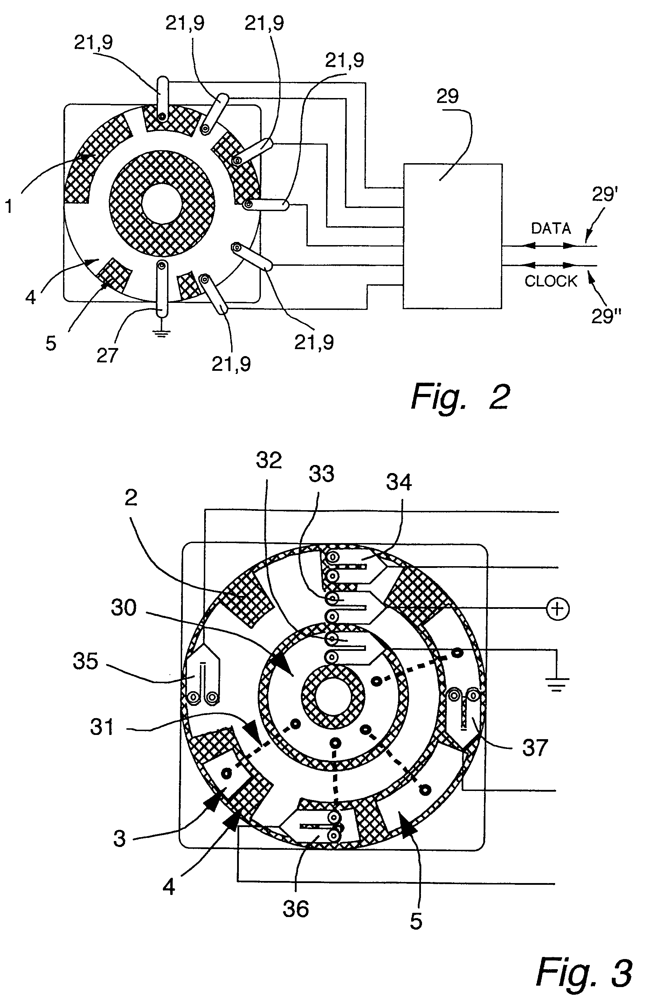

Figure 2 illustrates a case, where an 8 bit off-the-shelf bus driver IC is used to give the encoder a serial output, thus utilizing a two wire interface. In this embodiment of the invention six sensors 9 are provided in a form of six pickup contacts 21 that are arranged at an angular spacing of 30 degrees. A seventh contact 27 provides a ground reference to the coding wheel 1. The coding wheel 1 is patterned for 60 positions (i. e. there are 60 sectors each representing one of two different code values) in a manner similar to the previous example, except that now only two states are distinguished. In Figure 2 only the groups 4,5 of the different sectors 3 are shown and not each individual sector 3 itself. These sectors are "grounded" or "open". The binary code features a one bit change per transition so that no transient readings occur. An open contact will result in a high level signal due to the internal pull-up resistors of the interface circuit 29 (e.g. a serial bus interface 29 connected with a data input/output line 29' and a clock line 29'', respectively).

An encoder built is this fashion can be tied to a serial, bidirectional bus, where a cluster of devices can share the same two wires.

In a 64 position ternary setup, which is shown in figure 3, the sensors 9 of the encoder has a set of sliding contacts 34, 35, 36 and 37 distributed along a single track 2. The sliding contacts 34, 35, 36 and 37 are another embodiment for the sensors 9. The different portions of the track 2 are either grounded via a sliding contact 32, connected to the supply voltage via a sliding contact 33, or left open. The sectors 5 at the outer peripherical of the disc or coding wheel 1 are electrically isolated on the disc, however, connected with the inner ring-shaped portion 30 by wires 31. These wires 31 could be provided on the backside of the disc 1, i.e. on the other side of the wheel where no sliding contacts 34 to 37 are provided.

In other words in figure 3 the coding wheel or disc 1 is made of non-conducting material having different sectors 3 or groups of sectors 3 that are none-conducting and sectors 4 and 5 or groups of sectors 4 and 5, that are connected electrically to the supply voltage or to ground, respectively.

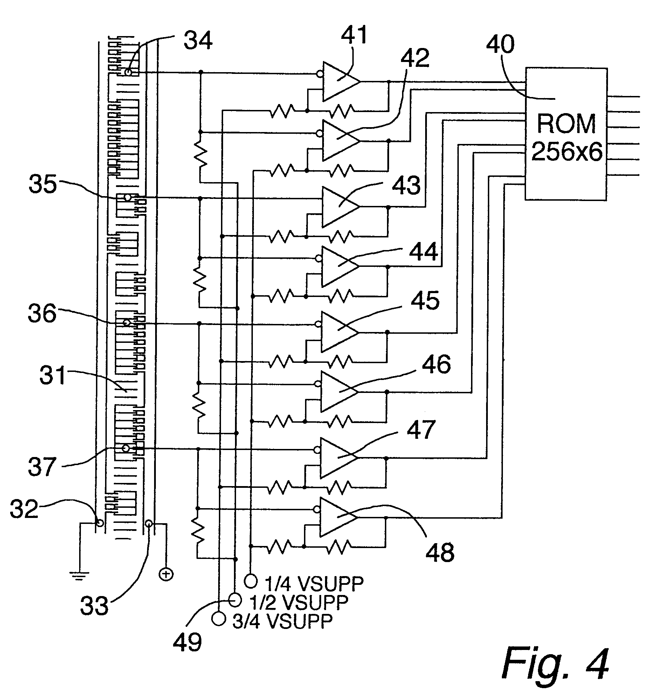

On the sensing side ( figure 4 ) a bank of comparators 41 to 48 is provided. Each of the four input lines from the respective sliding contacts 34 to 37 is resistively tied to a mid-point bias ( VSUPPLY) 49, so that an open input appears at half the supply voltage. Each channel is equipped with a pair of comparators defining three bands. A ROM table 40 ( 256 x 6 ) is then used to convert from the four pairs of lines representing a ternary code word to a natural binary output format.

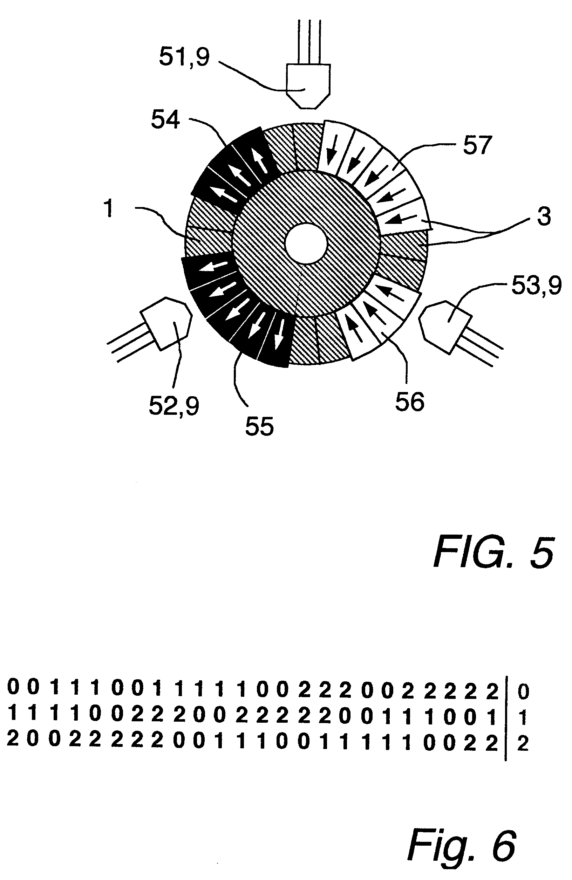

A first type of non-contacting scheme ( figure 5 ) utilizes a magnetized disc 1. For the set of sensors 9 in this embodiment a set of linear Hall sensors 51, 52 and 53 is provided. The disk features 24 segments of positive 54 and 55, zero, and negative 56 and 57 flux regions, arranged according to the pattern shown in the figure. The three Hall sensor outputs then become inputs to three pairs of comparators, arranged similar to the comparators shown in the circuit of figure 4. The ternary output signals of each of the three differential comparators is again fed to the table that converts from the comparator states to the final binary position output.

This 24 position converter is a good example to illustrate the main features of the inventive code: Figure 6 lists the consecutive states for a full 360° revolution. We note the following properties:
1) Each code word is unique (i.e. during one period of revolution or within the measuring region).
2) The code is cyclic, i.e. rules 3 and 4 also apply to the step from the last to the first element of the list (in figure 6 the rightest code word corresponds to the first code word in the first column on the left side).
3) Only one bit changes when moving between adjacent positions. This is the Gray code feature specifying a Hamming distance of 1 between adjacent elements.
4) No "jump" from 1 ( positive flux ) directly to 2 ( negative flux ) occurs since there's always a zone of zero flux between magnetized segments.

For a binary coded encoder, such as shown in figure 2, rules 1, 2 and 3 apply, whereas rule 4 is irrelevant.

With regard to the embodiment of figure 6 (which corresponds to the embodiment of figure 5) it is noted that there are 24 different sectors 3 at a whole. This is a result of that are 3³ possibilities = 27 whereby three states of this three level code embodiment namely the states (0, 0, 0), (1, 1, 1) and (2, 2, 2) are omitted.

In a case of a three level code with for example four sensors 9, there it is possible to provide 3⁴ -1 = 80 sectors 3 to obtain a resolution of 360° : 80 = 4,5°.

In this last example only the state (0, 0, 0, 0) should be omitted.

If a cost effective and low-power encoder is desired, a capacitive scheme has some very attractive features. Such a detector can be formed by zones on two pieces of printed circuit board placed in close proximity to each other. An AC signal applied to one of the plates is capacitively coupled to the opposing plate. The amplitude of the signal is a function of the amount of overlap between the two plates. For a ternary encoder three discrete states are distinguishable:
a) a signal exceeding a set threshold ( for example 50% of the amplitude at maximum coupling ) in phase with the reference oscillator.
b) a signal also exceeding the threshold but 180° out of phase.
c) a signal below the 50% threshold of either phase.

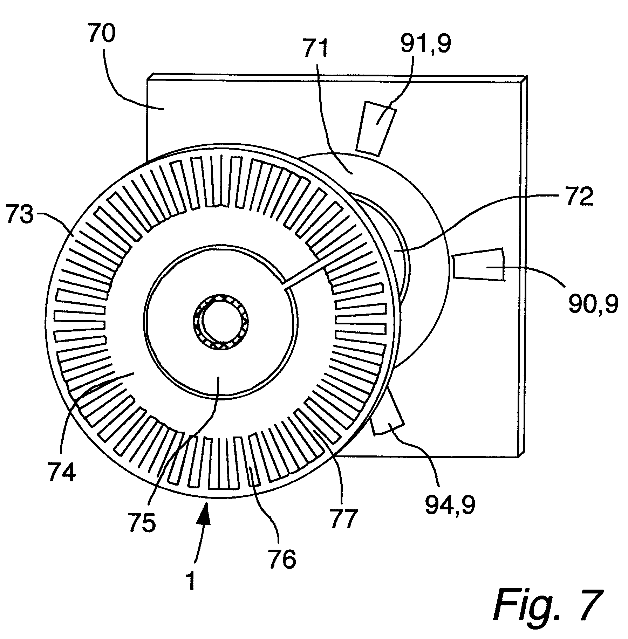

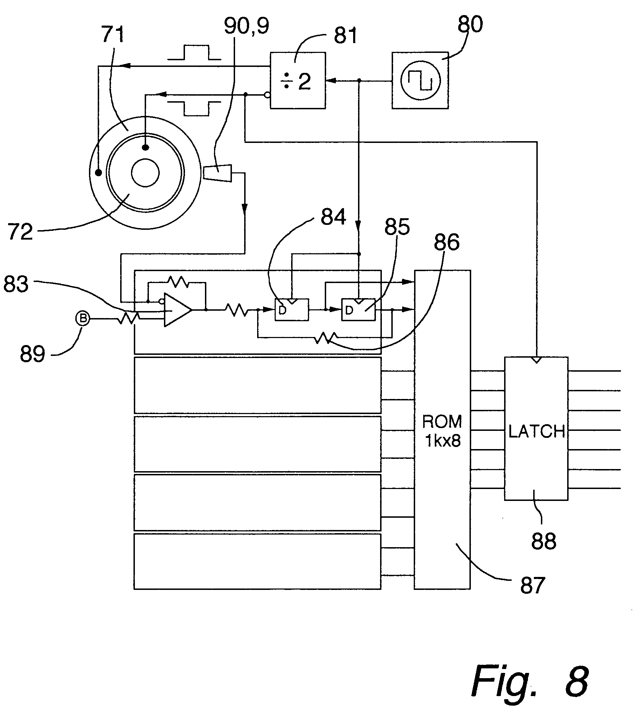

Figure 7 illustrates the arrangement of a 100 increment capacitive encoder. The stator 70 forming the coding disc or wheel 1, has two concentric electrodes 71 and 72 of equal surface area, one of which is driven by the direct output of an exciter 81 ( figure 8 ), and the other with its complement. The rotor disc 73 (corresponding to coding disc 1 in the other embodiments) has two ring-shaped electrodes 74 and 75 facing the stator electrodes 71 and 72, and capacitively picking up the exciter signals. The rotor further carries a plurality of fields 76 and 77 forming different sectors 3 which are each electrically connected either to the outer ring electrode 74 or to the inner ring electrode 75. Therefore a conducting bridge 75' is provided connecting the ring electrode 75 with the outer fields 77. These inner and outer fields 76, 77 are isolated against each other. These segments or sectors 3, i.e. fields 76, 77 thus each carry a signal either in phase or out of phase with regard to the exciter 81.

The stator 70 features five sensor segments 90 to 94 that are two increments wide and are spaced at equal intervals. These segments capacitively pick up the signal from either the in-phase or the out-of-phase excitation signal. Where two adjacent rotor fields of opposite phase e.g. 76 and its neighbor overlap with the sensor segment, the coupled signals cancel.

Figure 8 shows the circuitry connected to the capacitive encoder. An oscillator 80 followed by a frequency dividing exciter 81 generates the two complementary signals connected to the concentric electrodes 71 and 72 of stator 70. Since the detection circuitry is identical for each of the five channels, only one is shown. A high-impedance operational amplifier 83 amplifies the signal from the sensor segment 90. Two cascaded D-type flip-flops 84 and 85 act as synchronous detectors.

The input amplifier 83 is biased to a set point 89 so as to have the positive peaks of the amplified sensor segment output signal be above the threshold input level of the flip-flop 84, which is typically 50% of the supply voltage. A slight amount of positive feedback 86 has been added to provide Schmitt trigger action. The outputs of the detector circuits are connected to the inputs of a 1k x 7 ROM 87, that converts the 5 input line pairs to a 7 bit binary output code that is sampled by a latch 88. The ROM 87 is functionally equivalent to the ROM 40 of figure 4.

Extending the number of sensors, encoders with higher resolutions are possible. With 8 sensors, using two levels each ( binary ), the maximum number of positions that can be resolved is 240 in order to maintain the Gray code feature.

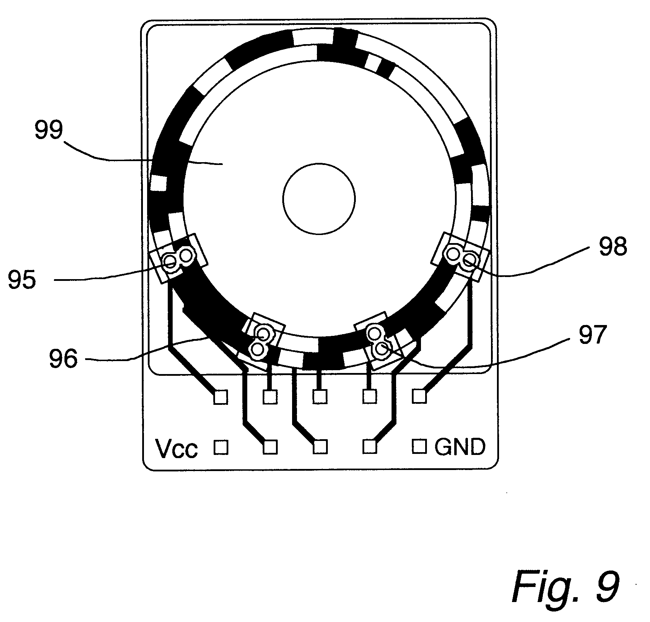

Since many industrial controllers operate on an 8 bit basis, providing an encoder with a 256 position resolution is desirable. The arrangement shown in figure 9 illustrates such a device. Four pairs of photo-transistors 95 to 98 are arranged along the circular track 2. Each pair is illuminated by an LED (not shown). The code inscribed to the wheel 1 is a quaternary ( = four level ) code.

Each detector pair senses the following states: 0, 1, 3, 2. The numbers are purposely listed in this sequence since only certain transitions are legal. (See also rules given to figure 6). In the above list each number can connect only to its neighbor, plus 0 connects to 2 and vice versa. This is again the Gray-code feature, which ensures glitchless transitions between states.

Each embodiment of the invention was discussed for the case that only one single track is provided which was subdivided into several sectors 3 representing the different states. In other words all sensors used are so arranged to detect the sectors positioned adjacent to each other on the same single track. However, it is within the scope of the invention not only to use one single track but to reduce the necessary tracks in such a way that the number of necessary tracks is smaller than the number of sensors provided for sensing the different codes (i. e. states of the different sectors). If, for example four sensors are provided, it is not necessary to use four tracks but to reduce the number of tracks to three or two tracks. However, the invention shows that it is even possible to use only one single track.

For the sake of illustration, the encoders shown as examples are all of moderate resolution. The described principle can, however, be applied to devices with much finer resolution. The limits of resolution are governed by the same physical constraints as apply to conventional, parallel encoders.

With regard to the different embodiments discussed above it is clear that the several sensors 9 as well as unique codes and code values could be so provided that the sensors 9 could be positioned in equal distances of a whole circle of 360° or e.g. in that way that the
Although several preferred embodiments have been shown and described in detail for illustrative purposes, it will be recognized that there are variations and modifications of these preferred embodiments, including the rearrangememt of parts, which lie within the scope of the present invention.

## Claims

1. A method of generating a numerical value representing an absolute position of a first member (1) with respect to a second member where said first and second members are supported for relative movement, comprising the steps of:
providing on said first member (1) an elongate track (2) having a code extending therealong;
sensing said code at a plurality of locations on said second member which are adjacent said track (2) at spaced locations therealong, said track (2) moving past each said location during relative movement of said first and second members (1);
generating a set of digital values which each represent a currently-sensed code value at a respective said location; and
converting said set of digital values representing currently sensed code values into a final binary output representative of an absolute position of said first member (1) with respect to said second (3, 4, 5) member.

2. A method according to Claim 1, wherein said currently sensed code values change to a different said code value each time said first member (1) is moved by a predetermined amount with respect to said second member, in a way as to allow only one of said digital values of said set to change each time said first member is moved by a predetermined amount with respect to said second member.

3. A method according to Claim 1 or 2, wherein said digital values are each a respective binary bit.

4. A method according to at least one of the Claims 1 to 3, wherein said digital values are each a respective ternary or quaternary word.

5. A method according to at least one of the Claims 1 to 4, wherein only one single track (2) is used having at least different code states.

6. A method according to at least one of the Claims 1 to 5, wherein the digital values of the code states are a one step code, especially a Gray-code whereby two adjacent sets of digital values have a Hamming distance of one.

7. An apparatus, comprising:
a first member (1) having thereon an elongated track (2) with a code extending therealong;
a second member having thereon a plurality of sensors (9) which are each adjacent said track (2) at spaced locations therealong,
the first member (1) with the elongated track (2) and/or the second member comprising the plurality of sensors (9) are supported for relative movement to each other,
said sensors (9) each moving along said track in response to relative movement of said first and second members (1); and
an electronic circuit which includes first means responsive to said sensors (9) for generating a set of digital values each representing a currently-sensed code value from a respective said sensor (9), and second means for converting said set of digital values representing said currently-sensed code values into a final binary output representative of an absolute position of said first member with respect to said second member.

8. An apparatus according to claim 7, wherein said first means includes means for causing the currently sensed code value to change to a different said code value each time said first member (1) is moved by a predetermined amount with respect to said second member only one of said digital values of said set changing each time said first member (1) is moved by said predetermined amount with respect to said second member.

9. An apparatus according to Claim 7 or 8, wherein each said digital value is represented as a binary bit.

10. An apparatus according to at least one of the Claims 7 to 9, wherein said second member is a stationary plate (70) supporting sensors (9) and said first member (1) is a disc which rotates relative to said plate (70), said first and second members (1) being supported in a common housing to form a compact shaft encoder.

11. An apparatus according to at least one of the Claims 7 to 10, wherein said second member is a stationary plate (70) supporting sensors (9) and said first member (1) is a linear scale moveable relative to said plate (70), said first and second members (1) forming a compact linear encoder.

12. An apparatus according to at least one of the Claims 7 to 11, wherein two adjacent sets of digital code values have a Hamming distance of one.

13. An apparatus according to at least one of the Claims 7 to 12, wherein only one single track (2) is provided with sectors (3) representing one of at least two different code values.
